# FASCICULE DE BREVET EUROPEEN

(11) **EP 3 175 518 B1**
(45) Date de publication et mention de la délivrance du brevet: **08.04.2020**
(21) Numéro de dépôt: 15754275.4
(22) Date de dépôt: 29.07.2015
(51) Int. Cl.: H01S 5/00, H01S 5/40, H01S 3/00

(54) **SOURCE LASER, APPAREIL ET PROCEDE POUR INTERAGIR SIMULTANEMENT AVEC PLUSIEURS ESPECES ATOMIQUES**
LASERQUELLE SOWIE VORRICHTUNG UND VERFAHREN ZUR GLEICHZEITIGEN INTERAKTION MIT EINER VIELZAHL VON ATOMAREM SPEZIES
LASER SOURCE, AND APPARATUS AND METHOD FOR SIMULTANEOUSLY INTERACTING WITH A PLURALITY OF ATOMIC SPECIES

(30) Priorité: 30.07.2014 FR 1457361
(43) Date de publication de la demande: 07.06.2017
(73) Titulaire: ONERA (Office National d'Etudes et de Recherches Aérospatiales), 91120 Palaiseau (FR)
(72) Inventeur: BIDEL, Yannick, 91761 Palaiseau (FR); ZAHZAM, Nassim, 91761 Palaiseau (FR); BRESSON, Alexandre, 91761 Palaiseau (FR)
(74) Mandataire: Plasseraud IP
(86) Numéro de dépôt international: PCT/FR2015/052104
(87) Numéro de publication internationale: WO 2016/016579

(56) Documents cités:
- JP-A- 01 321 340
- US-A1- 2012 224 243
- US-A1- 2013 293 895
- JIUTAO WU ET AL: "Erbium fiber laser based direct frequency comb spectroscopy of Rb two-photon transitions", OPTICS LETTERS, vol. 38, no. 23, 1 décembre 2013 (2013-12-01), pages 5028-5031, XP002737720,
- MÉNORET V ET AL: "Dual-wavelength laser source for onboard atom interferometry", OPTICS LETTERS, OPTICAL SOCIETY OF AMERICA, vol. 36, no. 21, 1 novembre 2011 (2011-11-01), pages 4128-4130, XP001570722, ISSN: 0146-9592, DOI: 10.1364/OL.36.004128 [extrait le 2011-10-19]
- ZHONGZHONG QIN ET AL: "Compact diode-laser-pumped quantum light source based on four-wave mixing in hot rubidium vapor", OPTICS LETTERS, OPTICAL SOCIETY OF AMERICA, vol. 37, no. 15, 1 août 2012 (2012-08-01), pages 3141-3143, XP001577497, ISSN: 0146-9592, DOI: 10.1364/OL.37.003141 [extrait le 2012-07-23]

## Description

La présente invention concerne une source laser, un appareil et un procédé pour interagir simultanément avec plusieurs espèces atomiques.

Dans le cadre de cette invention, on entend par interaction avec une espèce atomique un processus par lequel au moins une transition électronique est provoquée pour l'espèce atomique par absorption ou (et) émission de photons, en utilisant un rayonnement électromagnétique qui est envoyé sur des atomes de cette espèce. L'objectif de l'interaction peut être quelconque : piégeage d'un groupe d'atomes de l'espèce atomique, aussi appelé confinement spatial, refroidissement ou ralentissement d'atomes de cette espèce, séquence d'interférométrie d'ondes de matière qui est appliquée aux atomes, pompage optique des atomes, mesure d'une proportion de la population des atomes qui sont dans un état identifié, etc.

Le rayonnement électromagnétique qui est utilisé pour interagir avec une espèce atomique est adapté à celle-ci. Notamment, la longueur d'onde du rayonnement est adaptée en fonction de la transition électronique qui est provoquée pour cette espèce. Toutefois, en fonction de l'objectif pour lequel l'interaction est provoquée, cette longueur d'onde du rayonnement peut ne pas correspondre exactement à la longueur d'onde λₐₜ qui est associée à la transition électronique, tout en restant proche de sa valeur.

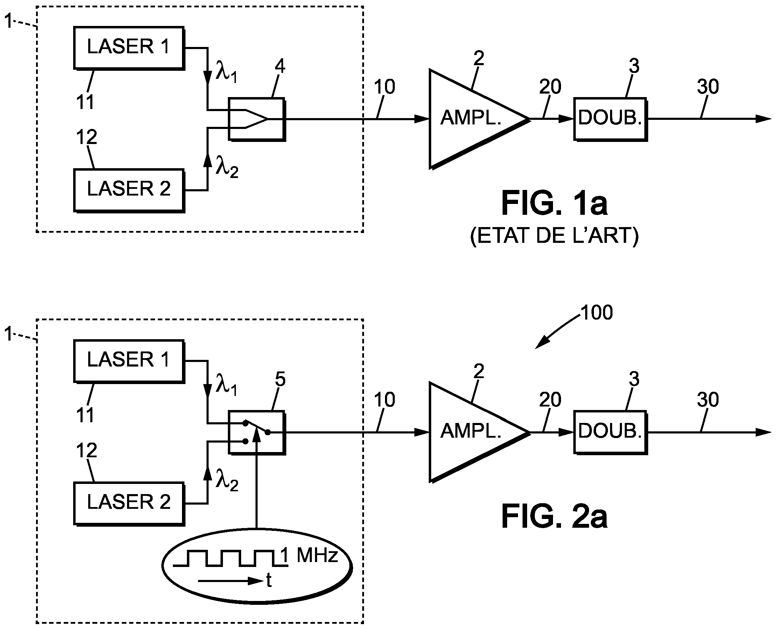

Or certaines applications nécessitent d'interagir simultanément avec plusieurs espèces atomiques. Il est alors nécessaire de produire plusieurs rayonnements électromagnétiques dont les longueurs d'onde correspondent respectivement aux espèces atomiques utilisées, afin de provoquer les transitions électroniques pour toutes les espèces atomiques à l'intérieur d'intervalles de temps qui sont communs. La Figure 1a illustre une source laser telle que connue avant la présente invention, qui permet d'atteindre ce but pour deux espèces atomiques différentes, en utilisant des solutions à base de doublage de fréquence. Les références numériques qui sont indiquées dans cette figure ont les significations suivantes :
1 : ensemble de génération de rayonnements laser,
2 : amplificateur optique, noté AMPL.,
3 : ensemble doubleur de fréquence optique, noté DOUB., et adapté pour doubler la fréquence du rayonnement qui est reçu en entrée par cet ensemble, et donc de diviser par deux sa longueur d'onde,
4 : combineur de faisceaux, adapté pour superposer deux faisceaux de rayonnements incidents à l'intérieur d'un même faisceau de sortie du combineur,
10: sortie de l'ensemble 1 de génération des rayonnements laser, connectée optiquement à une entrée unique de l'amplificateur 2,
20 : sortie de l'amplificateur 2, connectée optiquement à une entrée de l'ensemble doubleur de fréquence 3, et
30 : sortie de la source laser, à partir de laquelle les rayonnements sont disponibles pour interagir avec les espèces atomiques.

L'ensemble 1 peut comprendre lui-même deux unités laser distinctes 11 et 12 qui sont notées respectivement LASER 1 et LASER 2. Ces unités laser 11 et 12 produisent chacune un rayonnement laser dont la longueur d'onde initiale, λ₁ ou λ₂, est associée à l'une des espèces atomiques par l'intermédiaire de l'ensemble doubleur de fréquence 3. Autrement dit, la longueur d'onde λ₁ de l'unité laser 11 est proche de ou égale à 2·λₐₜ₁, où λₐₜ₁ est la longueur d'onde de transition électronique d'une première des espèces atomiques, et la longueur d'onde λ₂ de l'unité laser 12 est proche de ou égale à 2·λₐₜ₂, où λₐₜ₂ est la longueur d'onde de transition électronique d'une seconde des espèces atomiques. Les deux rayonnements des unités laser 11 et 12 sont superposés dans un même faisceau par le combineur 4, et le faisceau de superposition est envoyé en entrée de l'amplificateur 2. Ainsi, deux rayonnements laser sont délivrés continuellement à la sortie 30, dont les longueurs d'onde respectives sont proches de ou égales à λₐₜ₁ et λₐₜ₂. Jiutao

Wu et al. Dans Optics letters, vol. 38, no. 23, dec 1 2013 pages 5028 5031 décrit une spectroscopie à deux photons dans Rb dans laquelle un laser pulsé est modulé pour produire un peigne de fréquence qui est amplifié et doublé en fréquence. Les fréquences de la peigne sont ensuite temporairement séparées en utilisant un effet de chirp à moyen d'un réseau de diffraction. V. Ménoret et al. Dans Optics letters vol. 36, no. 21 novembre 2011, pages 4128-4130 décrit un signal laser pulsé à double longueur d'onde permettant d'effectuer une spectroscopie sur deux espèces d'atomes différentes en même temps. La lumière laser est amplifiée et la fréquence doublée.

Mais une telle source laser présente l'inconvénient suivant : la puissance maximale d'amplification Pₐₘₚₗ qui est disponible dans l'amplificateur 2 est répartie entre les deux rayonnements qui ont les longueurs d'onde initiales λ₁ et λ₂. Ainsi, chacun de ces rayonnements possède une puissance de l'ordre de Pₐₘₚₗ/2 à la sortie 20 de l'amplificateur 2. Par ailleurs et de façon connue, la puissance de chaque rayonnement à la sortie de l'ensemble doubleur de fréquence 3 est proportionnelle au carré de la puissance du rayonnement d'entrée correspondant. Ainsi, les puissances respectives P(λ₁/2) et P(λ₂/2) des rayonnements qui sont produits simultanément par la source laser pour interagir avec les deux espèces atomiques, avec les longueurs d'onde respectives λ₁/2 et λ₂/2, sont égales chacune à η·Pₐₘₗ²/4 où η est le facteur d'efficacité de l'ensemble doubleur de fréquence 3. Mais cette puissance de sortie peut être insuffisante pour obtenir les interactions souhaitées avec chaque espèce atomique.

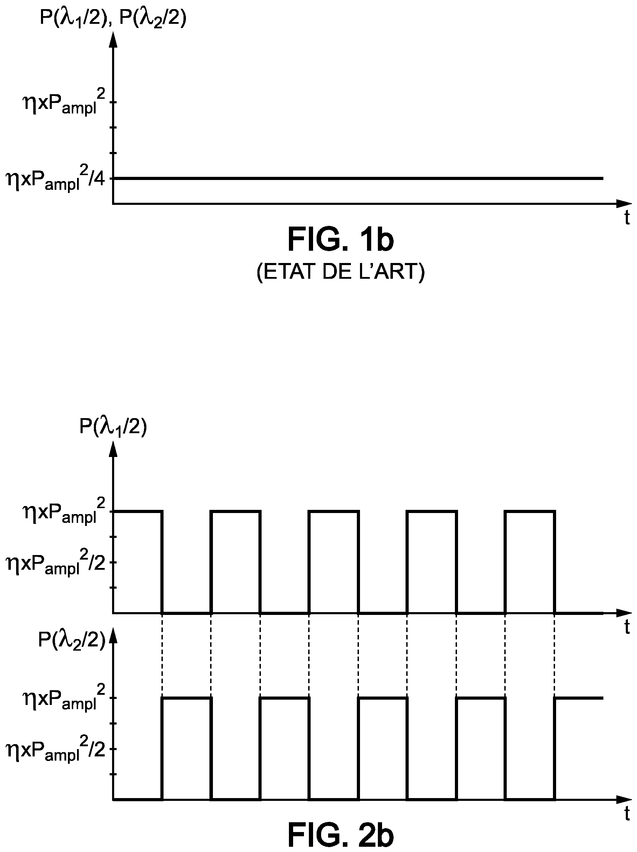

La Figure 1b est un diagramme temporel qui montre les puissances des deux rayonnements qui sont produits par la source laser pour interagir avec les deux espèces atomiques, respectivement aux longueurs d'onde λ₁/2 et λ₂/2, en fonction du temps noté t. Ces deux rayonnements d'interaction sont continus, avec des puissances respectives qui sont constantes et limitées à η·Pₐₘₚₗ²/4.

A partir de cette situation, un premier but de l'invention consiste à proposer une nouvelle source laser qui permette d'interagir avec une puissance laser supérieure pour chaque espèce atomique, sans augmenter le dimensionnement de l'amplificateur optique, c'est-à-dire pour une puissance maximale d'amplification Pₐₘₚₗ qui est identique.

Un but subsidiaire de l'invention est de proposer une telle source laser qui puisse être réalisée avec un nombre réduit de composants optiques, être compacte et avoir un prix de revient minimal.

Pour cela, la présente invention propose une source laser qui est destinée à un appareil pour interagir simultanément avec au moins deux espèces atomiques à l'intérieur d'intervalles de temps communs à ces espèces, au moyen d'au moins deux rayonnements d'interaction dédiés respectivement aux espèces et ayant des longueurs d'onde respectives qui sont distinctes. La source laser comprend :
- un ensemble de génération de rayonnements laser, qui est agencé pour produire des rayonnements initiaux correspondant un à un aux rayonnements d'interaction ;
- un amplificateur optique, qui est agencé pour recevoir en entrée les rayonnements initiaux et pour délivrer en sortie des rayonnements initiaux amplifiés ; et
- un ensemble doubleur de fréquence, qui est agencé pour recevoir en entrée les rayonnements initiaux amplifiés et pour produire en sortie les rayonnements d'interaction.

La source laser de l'invention est caractérisée en ce que l'ensemble de génération de rayonnements laser comprend des moyens de multiplexage temporel qui sont adaptés pour multiplexer les rayonnements initiaux en divisant chaque intervalle de temps en plusieurs sous-intervalles de temps successifs, et pour produire pendant chaque sous-intervalle de temps le rayonnement initial qui correspond au rayonnement d'interaction dédié à une des espèces à l'exclusion d'un autre des rayonnements initiaux qui correspond au rayonnement d'interaction dédié à une autre des espèces, et avec une alternance entre les rayonnements initiaux pour des sous-intervalles de temps successifs.

Ainsi, grâce au multiplexage temporel des rayonnements initiaux qui sont envoyés en entrée dans l'amplificateur optique, la puissance d'amplification maximale Pₐₘₚₗ qui est disponible à chaque instant du fonctionnement de la source laser, est consacrée à un seul des rayonnements destinés à interagir avec les espèces atomiques. Lorsque l'invention est appliquée à deux espèces atomiques, la puissance instantanée de chaque rayonnement initial amplifié est augmentée d'un facteur deux, et par suite la puissance instantanée de chaque rayonnement d'interaction est augmentée d'un facteur quatre, en aval de l'ensemble doubleur de fréquence. La puissance moyenne de chaque rayonnement d'interaction est ainsi augmentée d'un facteur deux dans le cas de deux espèces atomiques avec un seul rayonnement d'interaction qui est dédié à chaque espèce.

Lorsque l'invention est appliquée à trois espèces atomiques, la puissance instantanée de chaque rayonnement initial amplifié est augmentée d'un facteur trois, et par suite la puissance instantanée de chaque rayonnement d'interaction est augmentée d'un facteur neuf, en aval de l'ensemble doubleur de fréquence. La puissance moyenne de chaque rayonnement d'interaction est ainsi augmentée d'un facteur trois dans le cas de trois espèces atomiques avec un seul rayonnement d'interaction qui est dédié à chaque espèce.

Pour cela, le multiplexage temporel des rayonnements est réalisé à une fréquence qui est suffisamment élevée pour que le résultat de l'interaction entre chaque espèce atomique et le rayonnement qui lui est destiné soit identique au résultat de l'interaction avec un rayonnement continu. La durée de chaque sous-intervalle de temps ainsi que la durée entre deux sous-intervalles de temps successifs sont adaptées en fonction de paramètres physiques des transitions électroniques qui sont mises en œuvre pour les interactions. De préférence, les moyens de multiplexage peuvent être adaptés pour que chaque sous-intervalle de temps ait une durée qui soit comprise entre 0,1 microseconde et 1 milliseconde. Toutefois, la durée des sous-intervalles de temps qui sont dédiés à des espèces atomiques différentes, peut différer d'une espèce à l'autre en fonction des caractéristiques des transitions électroniques de toutes les espèces atomiques utilisées.

De préférence, le taux de remplissage du multiplexage temporel peut être supérieur à 90%. Le taux de remplissage du multiplexage est défini comme le rapport du temps pendant lequel la source laser délivre un rayonnement d'interaction à l'amplificateur sur la période de multiplexage.

Dans des modes préférés de réalisation de l'invention, les perfectionnements suivants peuvent être utilisés séparément ou en combinaison :
- l'ensemble de génération de rayonnements laser peut comprendre au moins une diode laser ou un laser à semi-conducteur qui est adapté pour produire un rayonnement dont la longueur d'onde est comprise entre 1500 nm et 1600 nm. Une telle unité laser peut être du type utilisé en télécommunication, et est peu onéreuse ;
- les moyens de multiplexage temporel peuvent comprendre au moins l'un parmi un commutateur optique et un modulateur acousto-optique ;
- l'ensemble de génération de rayonnements laser peut être adapté en outre pour produire pendant certains des sous-intervalles de temps, simultanément deux rayonnements initiaux correspondant respectivement à deux rayonnements d'interaction qui sont dédiés à une même des espèces atomiques. Dans ce cas, les deux rayonnements qui sont dédiés à la même espèce atomique produisent des interactions différentes avec cette espèce, telles qu'un repompage optique et une transition Raman stimulée, par exemple ;
- l'ensemble de génération de rayonnements laser peut comprendre au moins une unité laser qui est adaptée pour générer un rayonnement de base. Dans ce cas, l'ensemble est agencé de sorte qu'au moins deux des rayonnements initiaux soient obtenus à partir d'une modulation de ce rayonnement de base ; et
- l'ensemble doubleur de fréquence peut comprendre un cristal non-linéaire qui est agencé pour produire plusieurs des rayonnements d'interaction respectivement à partir des rayonnements initiaux amplifiés correspondants, reçus en entrée par le cristal non-linéaire.

L'invention propose en outre l'appareil pour interagir avec la pluralité des espèces atomiques à l'intérieur des intervalles de temps communs à ces espèces, lorsque cet appareil comprend :
- un ensemble de source d'atomes, qui est adapté pour délivrer des atomes appartenant aux espèces atomiques ;
- une source laser selon l'invention telle que décrite précédemment ; et
- des moyens pour diriger chaque rayonnement d'interaction qui est produit par l'ensemble doubleur de fréquence, sur une partie au moins des atomes de l'espèce à laquelle est dédié ce rayonnement d'interaction.

Dans un tel appareil, l'effet de l'interaction, le confinement par exemple, pour chaque espèce pendant une période de multiplexage n'est pas modifié par rapport à celui de l'interaction avec un rayonnement continu dédié à cette espèce.

Le rayonnement d'interaction qui est dédié à l'une au moins des espèces atomiques peut être adapté pour confiner spatialement des atomes de cette espèce, les refroidir, les ralentir, leur appliquer une séquence d'interférométrie d'onde de matière, les pomper optiquement ou mesurer une proportion de population de cette espèce qui est dans un état atomique.

Au moins un parmi le rubidium 85, le rubidium 87, le potassium 39 et le potassium 40 peut former l'une des espèces atomiques avec lesquelles interagit l'appareil de l'invention.

Enfin, l'invention propose encore un procédé pour interagir simultanément avec au moins deux espèces atomiques à l'intérieur d'intervalles de temps communs à ces espèces, au moyen d'au moins deux rayonnements d'interaction qui sont dédiés respectivement aux espèces et qui ont des longueurs d'onde respectives distinctes. Un tel procédé selon l'invention comprend les étapes suivantes :
/1/ diviser chaque intervalle de temps en plusieurs sous-intervalles de temps successifs ;
/2/ produire pendant chaque sous-intervalle de temps un rayonnement initial correspondant au rayonnement d'interaction qui est dédié à une des espèces à l'exclusion d'un autre rayonnement initial correspondant au rayonnement d'interaction qui est dédié à une autre des espèces, et avec une alternance entre les rayonnements initiaux pour des sous-intervalles de temps successifs ;
/3/ amplifier les rayonnements initiaux qui sont produits pendant les sous-intervalles de temps successifs en utilisant un même amplificateur optique pour ces rayonnements initiaux, afin d'obtenir des rayonnements initiaux amplifiés ;
/4/ doubler la fréquence de chaque rayonnement initial amplifié pour obtenir les rayonnements d'interaction ; et
/5/ diriger chaque rayonnement d'interaction au moins sur des atomes de l'espèce à laquelle est dédié ce rayonnement,
de sorte que l'effet de l'interaction pour chaque espèce pendant l'intervalle de temps total n'est pas modifié par rapport à celui de l'interaction avec un rayonnement continu dédié à ladite espèce.

D'autres particularités et avantages de la présente invention apparaîtront dans la description ci-après d'exemples de réalisation non limitatifs, en référence aux dessins annexés, dans lesquels :
- la Figure 1a, déjà décrite, est un schéma optique d'une source laser existant avant la présente invention ;
- la Figure 1b, aussi déjà décrite, est un diagramme temporel des puissances des rayonnements qui sont produits par une source laser conforme à la Figure 1a ;
- les Figures 2a et 2b correspondent respectivement aux Figures 1a et 1b pour une source laser conforme à la présente invention ;
- la Figure 3 représente un appareil selon l'invention ; et
- les Figures 4 et 5 correspondent à la Figure 2a respectivement pour deux perfectionnements de la présente invention.

Des références identiques qui sont indiquées dans des figures différentes désignent des éléments identiques ou qui ont des fonctions identiques. En outre, pour raison de clarté, l'utilisation de composants optiques qui ne sont pas représentés ni décrits est considérée comme relevant de la connaissance générale de l'Homme du métier.

L'invention est maintenant décrite dans le cas particulier d'interactions avec deux espèces atomiques seulement. A partir de cette description, l'Homme du métier saura adapter les sources laser destinées à deux espèces atomiques, pour obtenir des sources laser conformes à l'invention qui soient capables d'interagir simultanément avec trois espèces atomiques ou plus.

Conformément à la Figure 2a, une source laser selon l'invention qui est référencée 100 peut être obtenue à partir de la structure de la Figure 1a, en remplaçant le combineur 4 par un commutateur 5. Ce commutateur peut être un commutateur optique ou acousto-optique.

Les rayonnements initiaux aux longueurs d'onde λ₁ et λ₂ sont produits à la sortie 10 de l'ensemble 1 de génération des rayonnements laser. Les rayonnements initiaux amplifiés sont produits à la sortie 20 de l'amplificateur optique 2, et les rayonnements d'interaction sont produits à la sortie 30 de la source laser 100. L'ensemble doubleur de fréquence 3 réalise une division par deux de chaque longueur d'onde λ₁ et λ₂.

Le commutateur 5 peut être commandé par une fonction à variations temporelles en forme de créneaux, de sorte que le commutateur 5 transmette alternativement le rayonnement initial qui est produit par l'unité laser 11 ou celui qui est produit par l'unité laser 2, à l'amplificateur optique 2. L'intervalle de temps considéré peut être la durée de fonctionnement de la source laser 100, et les sous-intervalles de temps qui sont dédiés à une première des espèces atomiques peuvent être ceux pendant lesquels le commutateur 5 relie l'unité laser 11 à l'amplificateur 2. Les sous-intervalles de temps qui sont dédiés à la seconde espèce atomique sont alors ceux pendant lesquels le commutateur 5 relie l'unité laser 12 à l'amplificateur 2. Ainsi, les rayonnements initiaux aux longueurs d'onde λ₁ et λ₂ sont transmis alternativement à l'amplificateur 2.

La puissance instantanée de chaque rayonnement initial amplifié, tel qu'existant à la sortie 20 de l'amplificateur 2, est ainsi Pₐₘₚₗ, mais d'une façon qui est limitée à l'intérieur des sous-intervalles de temps pendant lesquels le commutateur 5 transmet le rayonnement initial correspondant à l'amplificateur 2. La fréquence de la fonction-créneau de commande du commutateur 5 peut être, par exemple, de l'ordre de 1 MHz (mégahertz).

Éventuellement, les deux unités laser 11 et 12 peuvent être remplacées par une unité laser unique à longueur d'onde variable. Cette unité variable est alors commandée pour produire alternativement les rayonnements initiaux avec les longueurs d'onde λ₁ et λ₂, selon une fréquence d'alternance qui peut encore être de l'ordre de 1 MHz.

Alternativement, les deux unités laser 11 et 12 peuvent être remplacées par une unité laser unique à longueur d'onde fixe, mais dont la longueur d'onde est modulée séparément en aval de l'unité laser, par une fréquence micro-onde qui est appliquée de façon discontinue.

La puissance instantanée de chacun des rayonnements d'interaction tels qu'existant à la sortie 30 de la source laser 100, avec les longueurs d'onde respectives λ₁/2 ou λ₂/2, est donc égale à η·Pₐₘₚₗ². Par conséquent, la puissance moyennée par rapport au temps t de chacun des rayonnements d'interaction est égale à η·Pₐₘₚₗ²/2, au lieu de η·Pₐₘₚₗ²/4 pour la source laser de la Figure 1a.

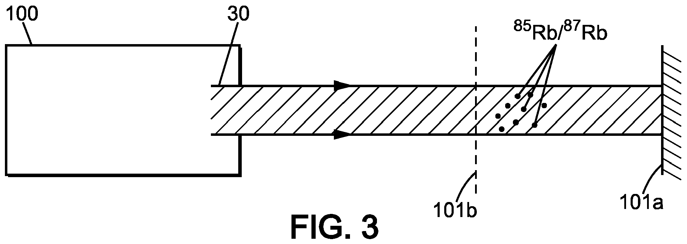

La Figure 3 représente un appareil conforme à l'invention, dans lequel des interactions avec les deux isotopes 85 et 87 du rubidium (⁸⁵Rb, ⁸⁷Rb) sont provoquées simultanément. Le faisceau des rayonnements d'interaction qui est produit à la sortie 30 de la source laser 100, est dirigé sur les atomes de rubidium 85 et de rubidium 87 en utilisant des composants optiques tels qu'un miroir 101a ou une lame semi-réfléchissante ou quart d'onde 101b. Des agencements possibles de ces composants pour diriger les rayonnements d'interaction sur les atomes sont connus de l'Homme du métier. Dans le cas particulier des atomes de rubidium, les deux unités laser 11 et 12 peuvent chacune être du type laser de télécommunication, avec des longueurs d'onde initiales respectives λ₁ et λ₂ chacune d'environ 1560 nm (nanomètre). La différence de longueur d'onde entre le rayonnement d'interaction qui est destiné à l'isotope 85 du rubidium et celui qui est destiné à l'isotope 87, c'est-à-dire λ₁/2 - λ₂/2, est d'environ 0,002 nm, correspondant à une fréquence micro-onde de 1 GHz (gigahertz). Pour cela, la différence entre les longueurs d'onde initiales λ₁ et λ₂ des unités laser 11 et 12 peut être d'environ 0,004 nm, correspondant à une fréquence micro-onde d'environ 0,5 GHz.

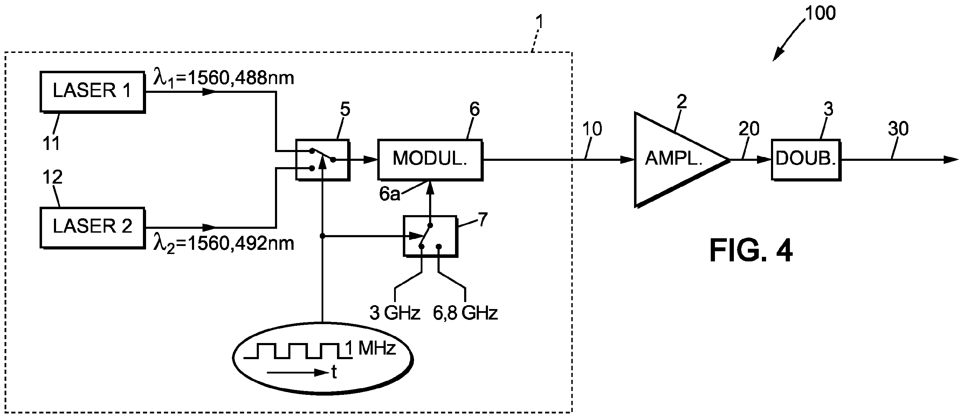

La source laser de la Figure 4 constitue un perfectionnement de celle de la Figure 2a. Selon ce premier perfectionnement, la source 100 fournit simultanément un rayonnement de repompage optique et un rayonnement pour stimuler des transitions Raman pour les atomes de rubidium 85 pendant les sous-intervalles de temps qui sont dédiés à cet isotope 85, et de même pour les atomes de rubidium 87 pendant les autres sous-intervalles de temps qui sont dédiés à l'isotope 87.

Pour cela, l'unité laser 11 peut être dédiée à l'isotope ⁸⁵Rb en étant adaptée pour produire un premier rayonnement laser initial à la longueur d'onde λ₁ égale à 1560,488 nm. Ce premier rayonnement initial est ensuite modulé selon une fréquence micro-onde de 3 GHz pour obtenir simultanément le rayonnement de repompage et le rayonnement de stimulation des transitions Raman pour ⁸⁵Rb.

Parallèlement, l'unité laser 12 peut être dédiée à l'isotope ⁸⁷Rb en étant adaptée pour produire un second rayonnement laser initial à la longueur d'onde λ₂ égale à 1560,492 nm. Ce second rayonnement initial est ensuite modulé selon une fréquence micro-onde de 6,8 GHz pour obtenir simultanément le rayonnement de repompage et le rayonnement de stimulation des transitions Raman pour ⁸⁷Rb.

Pour cela, la source laser de la Figure 4 peut être obtenue en insérant un modulateur de phase entre la sortie du commutateur 5 et la sortie 10 de l'ensemble 1 de génération des rayonnements laser. Ce modulateur de phase est noté MODUL. et référencé 6. Son entrée de commande de modulation 6a est alimentée alternativement avec un signal à la fréquence micro-onde de 3 GHz, ou avec un signal à la fréquence micro-onde de 6,8 GHz, par l'intermédiaire d'un commutateur électrique 7. Le commutateur 5 et le commutateur électrique 7 sont alors commandés de façon synchrone par le signal en fonction-créneau à environ 1 MHz. En outre, les commutateurs 5 et 7 sont connectés chacun en entrée pour que le commutateur 5 reçoive le rayonnement initial de l'unité 11 pendant les mêmes sous-intervalles de temps que ceux pour lesquels le commutateur 7 reçoit en entrée le signal micro-onde à 3 GHz.

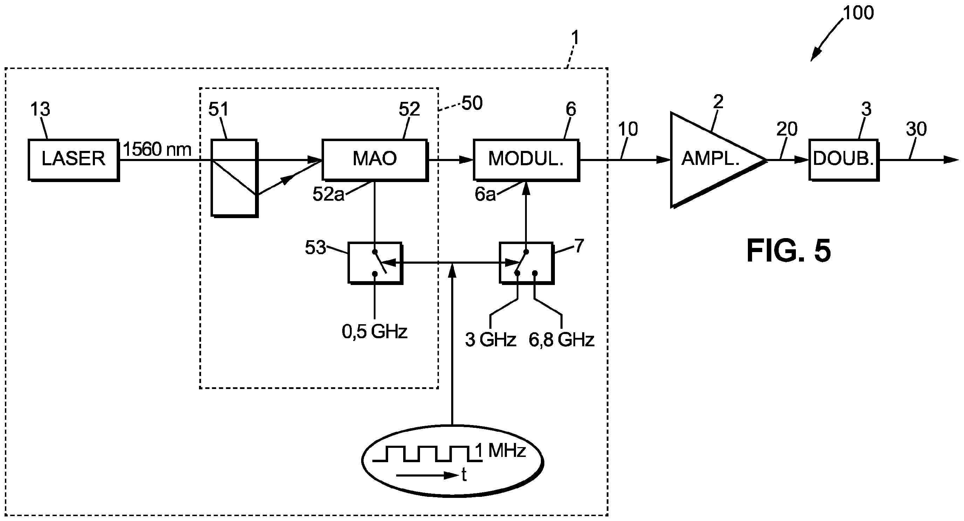

La Figure 5 illustre un perfectionnement supplémentaire, selon lequel la source 100 est réalisée à partir d'une unique unité laser 13, dont la longueur d'onde est fixe et encore voisine de 1560 nm. Pour cela, à partir de la structure de source laser de la Figure 4, le commutateur 5 est remplacé par un ensemble commutant 50 qui regroupe un diviseur de faisceau 51, un modulateur acousto-optique (MAO) 52 et un commutateur électrique supplémentaire 53. Le diviseur de faisceau 51 est alimenté en entrée par l'unité laser 13, et produit en sortie deux faisceaux qui sont introduits dans le modulateur acousto-optique 52 avec des incidences correspondant aux ordres de diffraction zéro et un pour une fréquence de modulation de 0,5 GHz. L'entrée de commande 52a du modulateur acousto-optique 52 est elle-même alimentée en signal de fréquence micro-onde environ égale à 0,5 GHz, d'une façon qui est synchronisée avec l'alimentation du modulateur de phase 6 en signal micro-onde à 3 GHz. Le rayonnement qui est produit à la sortie 10 de l'ensemble 1 de la Figure 5 est alors similaire à chaque instant à celui de l'ensemble 1 de la Figure 4.

Il est entendu que la présente invention peut être reproduite en adaptant certains détails de mise en œuvre qui ont été décrits ci-dessus, tout en conservant certains au moins des avantages qui ont été cités. Parmi ces adaptations, les suivantes sont énumérées de façon non-limitative :
- la source et l'appareil peuvent être adaptés pour interagir avec des atomes de potassium à la place ou en plus des atomes de rubidium. Les espèces atomiques utilisées ou certaines d'entre elles peuvent être l'isotope 39 du potassium (³⁹K) et/ou l'isotope 40 du potassium (⁴⁰K). Dans ce cas, les longueurs d'onde des rayonnements initiaux sont d'environ 1534 nm pour ces deux isotopes du potassium, au lieu de d'environ 1560 nm pour les isotopes du rubidium, et les fréquences micro-ondes sont 0,2 GHz pour l'isotope ³⁹K à la place de 6,8 GHz pour ⁸⁵Rb, et 0,6 GHz pour ⁴⁰K à la place de 3 GHz pour ⁸⁷Rb ;
- la source et l'appareil peuvent être conçus pour interagir simultanément avec plus de deux espèces atomiques, dont au moins un isotope du rubidium et au moins un isotope du potassium. Dans ce cas, il est préférable d'utiliser des doubleurs de fréquence différents pour les atomes de rubidium et ceux de potassium, à cause de la différence de longueur d'onde entre les rayonnements d'interaction qui sont dédiés respectivement aux atomes de rubidium et aux atomes de potassium ;
- des espèces atomiques différentes qui sont utilisées dans un appareil selon l'invention peuvent être situées ou non à un même endroit dans cet appareil au moment de leurs interactions avec les rayonnements correspondants ; et
- le modulateur acousto-optique 5 de la Figure 4 et l'ensemble commutant 50 de la Figure 5 peuvent être associés en parallèle au sein d'une même source laser selon l'invention, dans des voies optiques séparées qui alimentent en alternance l'amplificateur optique 2, et qui sont respectivement dédiées à des espèces atomiques différentes. Par exemple, une première voie d'alimentation peut être dédiée au rubidium, qui comprend au moins une première unité laser à 1560 nm et le modulateur acousto-optique 5, et une seconde voie peut être dédiée au potassium, qui comprend au moins une seconde unité laser à 1534 nm et l'ensemble commutant 50.

## Revendications

1. Source laser (100) destinée à un appareil pour interagir simultanément avec au moins deux espèces atomiques à l'intérieur d'intervalles de temps communs aux dites espèces, au moyen d'au moins deux rayonnements d'interaction dédiés respectivement aux dites espèces et ayant des longueurs d'onde respectives qui sont distinctes, la source laser comprenant :
- un ensemble de génération de rayonnements laser (1), agencé pour produire des rayonnements initiaux correspondant un-à-un aux rayonnements d'interaction ;
- un amplificateur optique (2), agencé pour recevoir en entrée les rayonnements initiaux et pour délivrer en sortie des rayonnements initiaux amplifiés ; et
- un ensemble doubleur de fréquence (3), agencé pour recevoir en entrée les rayonnements initiaux amplifiés et pour produire en sortie les rayonnements d'interaction,
**caractérisée en ce que** l'ensemble de génération de rayonnements laser (1) comprend des moyens de multiplexage temporel adaptés pour multiplexer les rayonnements initiaux en divisant chaque intervalle de temps en plusieurs sous-intervalles de temps successifs, et pour produire pendant chaque sous-intervalle de temps le rayonnement initial qui correspond au rayonnement d'interaction dédié à une des espèces à l'exclusion d'un autre des rayonnements initiaux qui correspond au rayonnement d'interaction dédié à une autre des espèces, et avec une alternance entre les rayonnements initiaux pour des sous-intervalles de temps successifs.

2. Source laser selon la revendication 1, dans laquelle les moyens de multiplexage temporel sont adaptés pour que chaque sous-intervalle de temps ait une durée comprise entre 0,1 microseconde et 1 milliseconde.

3. Source laser selon la revendication 1 ou 2, dans laquelle l'ensemble de génération de rayonnements laser (1) comprend au moins une diode laser ou un laser à semi-conducteur adapté pour produire un rayonnement de longueur d'onde comprise entre 1500 nm et 1600 nm.

4. Source laser selon l'une quelconque des revendications précédentes, dans laquelle les moyens de multiplexage temporel comprennent au moins un parmi un commutateur (5) et un modulateur acousto-optique (52).

5. Source laser selon l'une quelconque des revendications précédentes, dans laquelle l'ensemble de génération de rayonnements laser (1) est adapté en outre pour produire pendant certains des sous-intervalles de temps, simultanément deux rayonnements initiaux correspondant respectivement à deux rayonnements d'interaction qui sont dédiés à une même des espèces.

6. Source laser selon l'une quelconque des revendications précédentes, dans laquelle l'ensemble de génération de rayonnements laser (1) comprend au moins une unité laser (13) adaptée pour générer un rayonnement de base, et ledit ensemble de génération de rayonnements laser est agencé de sorte qu'au moins deux des rayonnements initiaux soient obtenus à partir d'une modulation dudit rayonnement de base.

7. Appareil pour interagir simultanément avec au moins deux espèces atomiques à l'intérieur d'intervalles de temps communs aux dites espèces, comprenant :
- un ensemble de source d'atomes, adapté pour délivrer des atomes appartenant aux dites au moins deux espèces atomiques ;
- une source laser (100) selon l'une quelconque des revendications précédentes ; et
- des moyens (101a, 101b) pour diriger chaque rayonnement d'interaction produit par l'ensemble doubleur de fréquence (3), sur une partie au moins des atomes de l'espèce à laquelle est dédié ledit rayonnement d'interaction ;
de sorte que l'effet de l'interaction pour chaque espèce pendant une période de multiplexage n'est pas modifié par rapport à celui de l'interaction avec un rayonnement continu dédié à ladite espèce.

8. Appareil selon la revendication 7, dans lequel au moins un des rayonnements d'interaction est adapté pour confiner spatialement des atomes de l'espèce à laquelle ledit rayonnement d'interaction est dédié, refroidir les dits atomes, ralentir les dits atomes, appliquer une séquence d'interférométrie d'onde de matière aux dits atomes, pomper optiquement les dits atomes, ou mesurer une proportion de population de ladite espèce qui est dans un état atomique.

9. Appareil selon revendication 7 ou 8, dans lequel au moins une des espèces atomiques est sélectionnée parmi le rubidium 85, le rubidium 87, le potassium 39 et le potassium 40.

10. Procédé pour interagir simultanément avec au moins deux espèces atomiques à l'intérieur d'intervalles de temps communs aux dites espèces, au moyen d'au moins deux rayonnements d'interaction dédiés respectivement aux dites espèces et ayant des longueurs d'onde respectives qui sont distinctes, le procédé comprenant les étapes suivantes :
/1/ diviser chaque intervalle de temps en plusieurs sous-intervalles de temps successifs ;
/2/ produire pendant chaque sous-intervalle de temps un rayonnement initial correspondant au rayonnement d'interaction dédié à une des espèces à l'exclusion d'un autre rayonnement initial correspondant au rayonnement d'interaction dédié à une autre des espèces, et avec une alternance entre les rayonnements initiaux pour des sous-intervalles de temps successifs ;
/3/ amplifier les rayonnements initiaux produits pendant les sous-intervalles de temps successifs en utilisant un même amplificateur optique (2) pour les dits rayonnements initiaux, afin d'obtenir des rayonnements initiaux amplifiés ;
/4/ doubler la fréquence de chaque rayonnement initial amplifié pour obtenir les rayonnements d'interaction ; et
/5/ diriger chaque rayonnement d'interaction au moins sur des atomes de l'espèce à laquelle est dédié ledit rayonnement d'interaction,
de sorte que l'effet de l'interaction pour chaque espèce après l'intervalle de temps total n'est pas modifié par rapport à celui de l'interaction avec un rayonnement continu dédié à ladite espèce.

## Patentansprüche

1. Laserquelle (100), die für eine Vorrichtung zur gleichzeitigen Wechselwirkung mit wenigstens zwei Atom-Spezies in für diese Spezies gemeinsamen Zeitintervallen bestimmt ist, und zwar mittels wenigstens zweier Wechselwirkungsstrahlungen, die diesen Spezies zugeordnet sind und jeweilige Wellenlängen aufweisen, die verschieden sind, wobei die Laserquelle umfasst:
- eine Anordnung zur Erzeugung von Laserstrahlungen (1), die dazu eingerichtet ist, Anfangsstrahlungen zu erzeugen, die den Wechselwirkungsstrahlungen eins zu eins entsprechen;
- einen optischen Verstärker (2), der dazu eingerichtet ist, die Anfangsstrahlungen als Eingabe zu empfangen und verstärkte Anfangsstrahlungen als Ausgabe auszugeben; und
- eine Frequenzverdoppler-Anordnung (3), die dazu eingerichtet ist, die verstärkten Anfangsstrahlungen als Eingabe zu empfangen und die Wechselwirkungsstrahlungen als Ausgabe zu erzeugen,
**dadurch gekennzeichnet, dass** die Anordnung zur Erzeugung von Laserstrahlungen (1) Zeitmultiplex-Mittel umfasst, die dazu angepasst sind, die Anfangsstrahlungen durch Unterteilen jedes Zeitintervalls in mehrere, aufeinanderfolgende Zeit-Teilintervalle zu multiplexen und während jedes Zeit-Teilintervalls die Anfangsstrahlung zu erzeugen, die der Wechselwirkungsstrahlung entspricht, welche einer der Spezies zugeordnet ist, unter Ausschluss einer anderen der Anfangsstrahlungen, die der Wechselwirkungsstrahlung entspricht, welche einer anderen der Spezies zugeordnet ist, und mit einem Wechsel zwischen den Anfangsstrahlungen für aufeinanderfolgende Zeit-Teilintervalle.

2. Laserquelle nach Anspruch 1, bei der die Zeitmultiplex-Mittel so angepasst sind, dass jedes Zeit-Teilintervall eine Dauer zwischen 0,1 Mikrosekunden und 1 Millisekunde hat.

3. Laserquelle nach Anspruch 1 oder 2, bei der die Anordnung zur Erzeugung von Laserstrahlungen (1) wenigstens eine Laserdiode oder einen Halbleiterlaser aufweist, der zur Erzeugung von Strahlung mit einer Wellenlänge zwischen 1500 nm und 1600 nm ausgelegt ist.

4. Laserquelle nach einem der vorhergehenden Ansprüche, bei der die Zeitmultiplex-Mittel einen Schalter (5) und/oder einen akustooptischen Modulator (52) umfassen.

5. Laserquelle nach einem der vorhergehenden Ansprüche, bei der die Anordnung zur Erzeugung von Laserstrahlungen (1) ferner dazu eingerichtet ist, während bestimmter Zeit-Teilintervalle gleichzeitig zwei Anfangsstrahlungen zu erzeugen, die jeweils zwei Wechselwirkungsstrahlungen entsprechen, die einer gleichen Spezies zugeordnet sind.

6. Laserquelle nach einem der vorhergehenden Ansprüche, bei der die Anordnung zur Erzeugung von Laserstrahlungen (1) wenigstens eine Lasereinheit (13) umfasst, die zur Erzeugung einer Basisstrahlung angepasst ist, und wobei die Anordnung zur Erzeugung von Laserstrahlungen so angeordnet ist, dass wenigstens zwei der Anfangsstrahlungen aus einer Modulation der Basisstrahlung erhalten werden.

7. Vorrichtung zur gleichzeitigen Wechselwirkung mit wenigstens zwei Atom-Spezies innerhalb von für diese Spezies gemeinsamen Zeitintervallen, umfassend:
- eine Anordnung von Atomquellen, die dazu ausgelegt ist, Atome zu liefern, die zu den wenigstens zwei Atom-Spezies gehören;
- eine Laserquelle (100) nach einem der vorhergehenden Ansprüche; und
- Mittel (101a, 101b), um jede Wechselwirkungsstrahlung, die von der Frequenzverdoppler-Anordnung (3) erzeugt wird, auf wenigstens einen Teil der Atome der Spezies zu richten, welcher die Wechselwirkungsstrahlung zugeordnet ist, so dass der Effekt der Wechselwirkung für jede Spezies während einer Multiplex-Periode im Vergleich zu demjenigen der Wechselwirkung mit einer kontinuierlichen Strahlung, die dieser Spezies zugeordnet ist, nicht verändert wird.

8. Vorrichtung nach Anspruch 7, wobei zumindest eine der Wechselwirkungsstrahlungen dazu ausgelegt ist, Atome der Spezies, welcher die Wechselwirkungsstrahlung zugeordnet ist, räumlich einzuschließen, die Atome zu kühlen, die Atome zu verlangsamen, eine Sequenz von Materiewellen-Interferometrie an den Atomen vorzunehmen, die Atome optisch zu pumpen oder einen Anteil der Population der Spezies zu messen, der sich in einem atomaren Zustand befindet.

9. Vorrichtung nach Anspruch 7 oder 8, bei der wenigstens eine der Atom-Spezies ausgewählt ist aus Rubidium 85, Rubidium 87, Kalium 39 und Kalium 40.

10. Verfahren zur gleichzeitigen Wechselwirkung mit wenigstens zwei Atom-Spezies innerhalb von für diese Spezies gemeinsamen Zeitintervallen mittels wenigstens zweier Wechselwirkungsstrahlungen, die jeweils diesen Spezies zugeordnet sind und jeweilige Wellenlängen aufweisen, welche verschieden sind, wobei das Verfahren die folgenden Schritte umfasst:
/1/ Unterteilen jedes Zeitintervalls in mehrere, aufeinanderfolgende Zeit-Teilintervalle;
/2/ Erzeugen, während jedes Zeit-Teilintervalls, einer Anfangsstrahlung, die der Wechselwirkungsstrahlung entspricht, die einer der Spezies zugeordnet ist, unter Ausschluss einer anderen Anfangsstrahlung, die der Wechselwirkungsstrahlung entspricht, die einer anderen der Spezies zugeordnet ist, und im Wechsel zwischen den Anfangsstrahlungen für aufeinanderfolgende Zeit-Teilintervalle;
/3/ Verstärken der Anfangsstrahlungen, die während der aufeinanderfolgenden Zeit-Teilintervalle erzeugt werden, unter Verwendung eines gleichen optischen Verstärkers (2) für die Anfangsstrahlungen, um verstärkte Anfangsstrahlungen zu erhalten;
/4/ Verdoppeln der Frequenz jeder verstärkten Anfangsstrahlung, um die Wechselwirkungsstrahlungen zu erhalten; und
/5/ Richten jeder Wechselwirkungsstrahlung zumindest auf Atome der Spezies, denen diese Wechselwirkungsstrahlung zugeordnet ist,
so dass der Effekt der Wechselwirkung für jede Spezies nach dem gesamten Zeitintervall im Vergleich zu demjenigen der Wechselwirkung mit einer kontinuierlichen Strahlung, die dieser Spezies zugeordnet ist, nicht modifiziert wird.

## Claims

1. A laser source (100) intended for a device for interacting simultaneously with at least two atomic species within time intervals which are common to said species, by means of at least two interaction radiations dedicated to said species respectively, and having distinct respective wavelengths, the laser source comprising:
- a laser radiation generating set (1), arranged for producing initial radiations corresponding one-to-one to the interaction radiations;
- an optical amplifier (2), arranged for receiving at input the initial radiations and for delivering at output amplified initial radiations; and
- a frequency doubler set (3), arranged for receiving at input the amplified initial radiations and for producing at output the interaction radiations,
**characterized in that** the laser radiation generating set (1) comprises means for time-division multiplexing adapted for multiplexing the initial radiations by dividing each time interval into several successive time sub-intervals, and for producing during each time sub-interval the initial radiation corresponding to the interaction radiation dedicated to one of the species upon exclusion of another one of the initial radiations corresponding to the interaction radiation dedicated to another one of the species, and with alternation between the initial radiations for successive time sub-intervals.

2. The laser source according to Claim 1, wherein the means for time-division multiplexing are adapted so that each time sub-interval has a duration comprised between 0.1 microseconds and 1 millisecond.

3. The laser source according to Claim 1 or 2, wherein the laser radiation generating set (1) comprises at least one laser diode or semiconductor laser adapted to produce a radiation with a wavelength comprised between 1500 nm and 1600 nm.

4. The laser source according to any of the preceding claims, wherein the means for time-division multiplexing comprise at least one of a switch (5) or an acousto-optical modulator (52).

5. The laser source according to one of the preceding claims, wherein the laser radiation generating set (1) is further adapted to produce simultaneously, during some of the time sub-intervals, two initial radiations corresponding respectively to two interaction radiations which are dedicated to a same one of the species.

6. The laser source according to any of the preceding claims, wherein the laser radiation generating set (1) comprises at least one laser unit (13) adapted to generate at base radiation, and said laser radiation generating set is arranged so that at least two of the initial radiations are obtained from a modulation of said base radiation.

7. A device for interacting simultaneously with at least two atomic species within time intervals which are common to said species, comprising:
- an atom source set, adapted to deliver atoms belonging to said at least two atomic species;
- a laser source (100) according to any of the preceding claims; and
- means (101a, 101b) for directing each interaction radiation produced by the frequency doubler set (3), onto at least part of the atoms of the species to which said interaction radiation is dedicated;
so that the effect of the interaction for each species during a multiplexing period is not modified with respect to that of the interaction with a continuous radiation dedicated to said species.

8. The device according to Claim 7, wherein at least one of the interaction radiations is adapted to spatially confine atoms of the species to which said interaction radiation is dedicated, cooling said atoms, slowing said atoms down, applying a sequence of matter wave interferometry to said atoms, optically pumping said atoms, or measuring a population proportion of said species which is in an atomic state.

9. The device according to Claim 7 or 8, wherein at least one of the atomic species is selected from rubidium 85, rubidium 87, potassium 39, and potassium 40.

10. A method for interacting simultaneously with at least two atomic species within time intervals which are common to said species, by means of at least two interaction radiations dedicated to said species respectively, and having distinct respective wavelengths, the method comprising the steps of:
/1/ dividing each time interval into several successive time sub-intervals;
/2/ producing during each time sub-interval an initial radiation corresponding to the interaction radiation dedicated to one of the species upon exclusion of another initial radiation corresponding to the interaction radiation dedicated to another one of said species, and with alternation between the initial radiations for successive time sub-intervals;
/3/ amplifying the initial radiations produced during the successive time sub-intervals using one same optical amplifier (2) for said initial radiations, to obtain amplified initial radiations;
/4/ doubling the frequency of each amplified initial radiation to obtain the interaction radiations; and
/5/ directing each interaction radiation at least onto atoms from the species to which said interaction radiation is dedicated,
so that the effect of the interaction for each species after the total time interval is not modified with respect to that of the interaction with a continuous radiation dedicated to said species.
